# EUROPEAN PATENT APPLICATION

(11) **EP 4 769 414 A1**
(43) Date of publication of application: **01.07.2026**
(21) Application number: 25810955.2
(22) Date of filing: 21.05.2025
(51) Int. Cl.: G11C 29/42

(54) **MEMORY, OPERATION METHOD FOR MEMORY, AND MEMORY DEVICE**

(30) Priority: 18.10.2024 CN 202411455976
(71) Applicant: CXMT Corporation, Hefei City, Anhui Province 230601 (CN)
(72) Inventor: CAO, Kanyu, Hefei, Anhui 230601 (CN); HUANG, Zequn, Hefei, Anhui 230601 (CN); YU, Qiang, Hefei, Anhui 230601 (CN); LU, Tianchen, Hefei, Anhui 230601 (CN)
(74) Representative: Gulde & Partner
(86) International application number: PCT/CN2025/096163
(87) International publication number: WO 2026/081479

(57) **Abstract**

A memory, a memory operation method, and a storage device are provided. The memory includes multiple banks, multiple error checking circuits, and an error address generation circuit. Each of the banks includes multiple data memory array tiles and an ECC memory array tile. Each of the error checking circuits is configured to separately read stored data and check data from the bank, and generate a corresponding error checking signal based on the stored data and the check data. The error address generation circuit is configured to receive multiple error checking signals from the multiple error checking circuits, and when any one of the error checking signals is at an inactive level, store address information corresponding to an error failing to meet a condition. In this way, an on-die ECC may be employed to pre-identify an error occurring in the memory, and after an error uncorrectable by the on-die ECC is identified, an error checking signal is generated to record error address information in a timely manner, thereby facilitating subsequent correction of the error and improving accuracy of the memory.

## Description

### CROSS-REFERENCE TO RELATED APPLICATIONS

This application is based on and claims priority of the Chinese Patent Application No. 202411455976.8, filed with China National Intellectual Property Administration on October 18, 2024 and entitled "MEMORY, MEMORY OPERATION METHOD, AND STORAGE DEVICE". The above-referenced application is incorporated herein by reference in its entirety.

### TECHNICAL FIELD

Embodiments of the present disclosure relate to the field of semiconductor technologies, and in particular, to a memory, a memory operation method, and a storage device.

### BACKGROUND

In the semiconductor industry, a memory cell of a memory chip such as a dynamic random access memory (Dynamic Random Access Memory, DRAM) includes one transistor and one capacitor. The DRAM completes a data write operation on the memory by storing a charge into the capacitor of the memory cell, and completes a data read operation on the memory by reading a charge from the capacitor of the memory cell. With the development of semiconductor technologies, an integration level of the DRAM is increasingly high, and a quantity of error occurrence times increases accordingly. In some cases, an ECC encoding and/or decoding circuit may be employed to perform an error correction function to correct an error bit.

### SUMMARY

Embodiments of the present disclosure provide a memory, a memory operation method, and a storage device.

According to some embodiments of the present disclosure, a first aspect of the embodiments of the present disclosure provides a memory. The memory includes: multiple banks, each of the banks including multiple data memory array tiles and an ECC memory array tile; multiple error checking circuits having a one-to-one correspondence with the multiple banks; each of the error checking circuits being configured to respectively read stored data and check data from the multiple data memory array tiles and the ECC memory array tile of the corresponding bank, and generate a corresponding error checking signal based on the stored data and the check data, the error checking signal being configured to indicate whether an error meeting a condition occurs on the stored data and/or the check data of the corresponding bank; and an error address generation circuit, configured to receive the multiple error checking signals from the multiple error checking circuits, and store address information corresponding to an error failing to meet a condition when any one of the error checking signals is at an inactive level. The address information includes error row address information and error column address information.

In some embodiments, the error address generation circuit is further configured to generate and store error identification information when any one of the error checking signals is at an inactive level. The error identification information is configured to indicate whether an error failing to meet a condition occurs on stored data and/or check data corresponding to the stored address information.

In some embodiments, the error checking circuit includes: a first checking circuit, configured to receive the stored data and the check data, and compare a check code generated based on the stored data with the check data to generate a comparison result; and a first determining circuit, configured to receive the comparison result and determine whether the comparison result meets a condition, and generate the error checking signal at an active level when the comparison result meets the condition, or generate the error checking signal at an inactive level when the comparison result does not meet the condition.

In some embodiments, the error address generation circuit includes: a combining circuit, configured to receive the multiple error checking signals corresponding to the multiple banks, and combine the multiple error checking signals to generate an error checking total signal, where when any one of the error checking signals is at an inactive level, the generated error checking total signal is at an inactive level; a row address generation circuit, configured to receive the multiple error checking signals and the error checking total signal, and when any one of the error checking signals is at an inactive level, output row address information of the corresponding bank as error row address information, and store the error row address information in response to the error checking total signal at an inactive level; and a column address generation circuit, configured to store error column address information corresponding to an error failing to meet a condition in response to the error checking total signal at an inactive level.

In some embodiments, the row address generation circuit includes: multiple row address latch circuits having a one-to-one correspondence with the multiple banks, each of the row address latch circuits being configured to latch, in response to an activation signal of the corresponding bank, row address information corresponding to the activation signal; a row address selection circuit, configured to receive the multiple error checking signals and multiple pieces of row address information latched by the multiple row address latch circuits, and when any one of the error checking signals is at an inactive level, output corresponding row address information as error row address information; and a row address storage circuit, configured to store the error row address information in response to the error checking total signal at an inactive level.

In some embodiments, the column address generation circuit includes: a column address latch circuit, configured to input, in response to a read signal, column address information corresponding to the read signal into a buffer, and output, in response to a read delay signal, the column address information corresponding to the read signal from the buffer as error column address information; the read delay signal being a delay signal of the read signal; and a column address storage circuit, configured to store the error column address information into a corresponding mode register in response to the error checking total signal at an inactive level.

In some embodiments, the row address storage circuit includes N serially connected row address storage subcircuits. A 1st row address storage subcircuit is configured to store received error row address information when an error checking total signal on which a first delay is performed for N-1 times is at an inactive level. An ith row address storage subcircuit is configured to receive and store error row address information stored in an (i-1)th row address storage subcircuit, when an error checking total signal on which a first delay is performed for N-i times is at an inactive level. An Nth row address storage subcircuit is configured to receive and store error row address information stored in an (N-1)th row address storage subcircuit, when the error checking total signal is at an inactive level. The first delay is several clock cycles, N is greater than or equal to 2, and i is a positive integer greater than 1 and less than N. The column address storage circuit includes N serially connected column address storage subcircuits. A 1st column address storage subcircuit is configured to store received error column address information when an error checking total signal on which a second delay is performed for N-1 times is at an inactive level. A jth column address storage subcircuit is configured to receive and store error column address information stored in a (j-1)th column address storage subcircuit, when an error checking total signal on which a second delay is performed for N-j times is at an inactive level. An Nth column address storage subcircuit is configured to receive and store error column address information stored in an (N-1)th column address storage subcircuit, when the error checking total signal is at an inactive level. The second delay is several clock cycles, and j is a positive integer greater than 1 and less than N.

According to some embodiments of the present disclosure, a second aspect of the embodiments of the present disclosure further provides a memory operation method. A memory includes multiple banks, and each of the banks includes multiple data memory array tiles and an ECC memory array tile. The operation method includes the following steps: Stored data and check data that are respectively read from the multiple data memory array tiles and the ECC memory array tile of any one of the banks are received, and a corresponding error checking signal is generated based on the stored data and the check data. The error checking signal is configured to indicate whether an error meeting a condition occurs on the stored data and/or the check data of the corresponding bank. The error checking signal is received, and address information corresponding to an error failing to meet a condition when the error checking signal is at an inactive level. The address information includes error row address information and error column address information.

In some embodiments, error identification information is generated and stored when the error checking signal is at an inactive level. The error identification information is configured to indicate whether an error failing to meet a condition occurs on stored data and/or check data corresponding to the stored address information.

In some embodiments, before the stored data and the check data that are respectively read from the multiple data memory array tiles and the ECC memory array tile of the corresponding bank are received, the operation method further includes the following steps: In response to an activation signal, row address information of a bank corresponding to the activation signal is received and latched. In response to a read signal, column address information corresponding to the read signal is received and input into a buffer.

In some embodiments, the generating a corresponding error checking signal based on the stored data and the check data includes the following steps: A check code is generated based on the stored data, and the check code is compared with the check data to generate a comparison result. The comparison result is received and it is determined whether the comparison result meets a condition. The error checking signal at an active level is generated when the comparison result meets the condition, or the error checking signal at an inactive level is generated when the comparison result does not meet the condition.

In some embodiments, the receiving the error checking signal, and storing address information corresponding to an error failing to meet a condition when the error checking signal is at an inactive level includes the following steps: Multiple error checking signals corresponding to multiple banks are received and combined to generate an error checking total signal. When any one of the error checking signals is at an inactive level, an error checking total signal at an inactive level is generated. The received address information is selected in response to the multiple error checking signals to generate error row address information and error column address information. The error row address information and the error column address information are stored in response to the error checking total signal.

In some embodiments, the selecting the received address information in response to the multiple error checking signals to generate error row address information and error column address information includes the following steps: The multiple error checking signals and multiple pieces of row address information corresponding to the multiple banks are received, and when any one of the error checking signals is at an inactive level, row address information of the corresponding bank is output as error row address information. In response to a read delay signal, the column address information corresponding to the read signal is output from the buffer as error column address information. The read delay signal is a delay signal of the read signal.

According to some embodiments of the present disclosure, a third aspect of the embodiments of the present disclosure further provides a storage device. The storage device includes multiple memories according to the first aspect and multiple ECC chips. The error row address information and the error column address information in the memories are configured to determine a data location at which an error failing to meet a condition occurs, and check data stored in the ECC chips is configured to perform error checking and error correction on stored data and/or check data corresponding to the error row address information and the error column address information.

Embodiments of the present disclosure provide a memory, a memory operation method, and a storage device. The memory includes: multiple banks and multiple ECC memory array tiles; multiple error checking circuits, configured to receive stored data read from a corresponding bank and check data read from a corresponding ECC memory array tile, and generate an error checking signal, the error checking signal being configured to indicate whether an error meeting a condition occurs on the stored data and/or the check data; and an error address generation circuit, configured to receive address information and store, into a mode register, address information corresponding to an error failing to meet a condition in response to any error checking signal. In this way, the error checking circuit may be employed to detect whether an error meeting a condition occurs on a bank and/or an ECC memory array tile, and the error address generation circuit may be employed to store, into the mode register, address information corresponding to an error failing to meet a condition. In this way, an on-die ECC may be employed to pre-identify an error occurring in the memory, and after an error uncorrectable by the on-die ECC is identified, an error checking signal is generated to record error address information in a timely manner, thereby facilitating subsequent correction of the error and improving accuracy of the memory.

### BRIEF DESCRIPTION OF DRAWINGS

One or more embodiments are described by way of example with the figures in the accompanying drawings corresponding to the one or more embodiments. These example descriptions do not constitute a limitation on the embodiments. Elements with the same reference numerals in the accompanying drawings are similar elements, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.
FIG. 1 is a schematic diagram of a compositional structure of a memory according to an embodiment of the present disclosure;
FIG. 2 is a schematic diagram of a compositional structure of an error checking circuit according to an embodiment of the present disclosure;
FIG. 3 is a schematic diagram of a compositional structure of an error address generation circuit according to an embodiment of the present disclosure;
FIG. 4 is a schematic diagram of a data configuration of a mode register according to an embodiment of the present disclosure;
FIG. 5 is a schematic diagram of a compositional structure of a row address generation circuit according to an embodiment of the present disclosure;
FIG. 6 is a schematic circuit diagram of a row address generation circuit according to an embodiment of the present disclosure;
FIG. 7 is a schematic diagram of a compositional structure of a column address generation circuit according to an embodiment of the present disclosure;
FIG. 8 is a schematic circuit diagram of a column address generation circuit according to an embodiment of the present disclosure;
FIG. 9 is a schematic diagram of a compositional structure of a row address storage circuit and a column address storage circuit according to an embodiment of the present disclosure;
FIG. 10 is a schematic circuit diagram of a row address storage circuit and a column address storage circuit according to an embodiment of the present disclosure;
FIG. 11 is a schematic diagram of a procedure step of a memory operation method according to an embodiment of the present disclosure;
FIG. 12 is a schematic diagram of another procedure step of a memory operation method according to an embodiment of the present disclosure;
FIG. 13 is a schematic diagram of another procedure step of a memory operation method according to an embodiment of the present disclosure;
FIG. 14 is a schematic diagram of another procedure step of a memory operation method according to an embodiment of the present disclosure;
FIG. 15 is a schematic diagram of another procedure step of a memory operation method according to an embodiment of the present disclosure;
FIG. 16 is a schematic diagram of another procedure step of a memory operation method according to an embodiment of the present disclosure; and

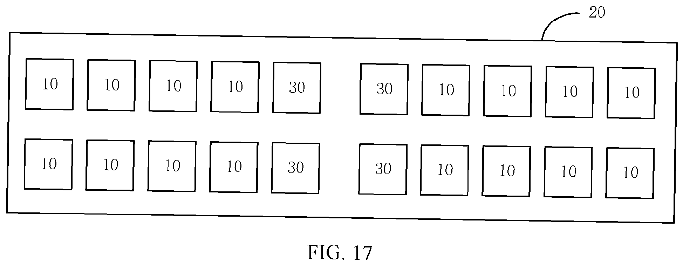

FIG. 17 is a schematic diagram of a compositional structure of a storage device according to an embodiment of the present disclosure.

### DESCRIPTION OF EMBODIMENTS

To make the objectives, technical solutions, and advantages of embodiments of the present disclosure clearer, the following clearly and comprehensively describes the technical solutions in the embodiments of the present disclosure with reference to the accompanying drawings in the embodiments of the present disclosure. Clearly, the described embodiments are some rather than all of the embodiments of the present disclosure. All other embodiments obtained by a person of ordinary skill in the art based on the embodiments of the present disclosure without creative efforts shall fall within the protection scope of the present disclosure. In addition, although the content disclosed in the present disclosure is described based on one or more instances by way of example, it should be understood that each aspect of the disclosed content may separately constitute a complete implementation.

It should be noted that brief description of terms in the present disclosure is merely intended to facilitate understanding of the implementations described below, and is not intended to limit the implementations of the present disclosure. Unless otherwise specified, these terms should be understood based on ordinary and common meanings thereof.

The terms "first", "second", and the like in the specification, claims, and accompanying drawings of the present disclosure are intended to distinguish between similar or same objects or entities, and do not necessarily indicate a specific order or sequence, unless otherwise noted. It should be understood that the terms employed in such a manner are interchangeable under appropriate circumstances, for example, can be implemented in an order other than those given in the illustrations or descriptions of the embodiments of the present disclosure.

In addition, the terms "comprise", "include", "have", and any variants thereof are intended to cover non-exclusive inclusion. For example, a product or a device including a series of components is not necessarily limited to the components that are expressly listed, and may include another component that is not expressly listed or is inherent to the product or the device.

The term "module" employed in the present disclosure refers to a combination of any known or later developed hardware, software, firmware, artificial intelligence, fuzzy logic, or hardware or/and software code, and can perform a function related to the element.

In a current application of a memory, stability and correctness of storing data by the memory may be improved by employing an error checking and correcting (Error Checking and Correcting, ECC) technology. The ECC includes sideband ECC (side band ECC) and on-die ECC (on-die ECC). For the sideband ECC, an additional DRAM chip is disposed on a memory module for storing an ECC code, and then the error checking and correcting technology is implemented in a controller through an additional data bus for the ECC. The on-die ECC is implemented in a DRAM chip. An ECC storage area is additionally disposed outside a primary storage area configured to store data, so as to store ECC check data. Because the on-die ECC is integrated into the chip, the data can be directly corrected by employing the technology during computing or transmission, without requiring additional processing or transmission, thereby greatly reducing a transmission delay and energy consumption. However, the on-die ECC can only be employed to check and correct a single-bit error.

An embodiment of the present disclosure provides a memory. The memory includes: multiple banks, each of the banks including multiple data memory array tiles and an ECC memory array tile; multiple error checking circuits having a one-to-one correspondence with the multiple banks; each of the error checking circuits being configured to respectively read stored data and check data from the multiple data memory array tiles and the ECC memory array tile of the corresponding bank, and generate a corresponding error checking signal based on the stored data and the check data, the error checking signal being configured to indicate whether an error meeting a condition occurs on the stored data and/or the check data of the corresponding bank; and an error address generation circuit, configured to receive the multiple error checking signals from the multiple error checking circuits, and store, into a mode register for storage, address information corresponding to an error failing to meet a condition when any one of the error checking signals is at an inactive level. The address information includes error row address information and error column address information. In this way, an on-die ECC may be employed to pre-identify an error occurring in the memory, and after an error uncorrectable by the on-die ECC is identified, error address information is recorded in a timely manner according to an indication of a generated error checking signal, thereby facilitating subsequent correction of the error and improving accuracy of the memory.

The embodiments of the present disclosure are described in detail below with reference to the accompanying drawings. However, it may be understood by a person of ordinary skill in the art that in the embodiments of the present disclosure, many technical details are provided to enable readers to better understand the present disclosure. However, the technical solutions claimed in the present disclosure may be implemented even without these technical details and various variations and modifications made based on the following embodiments.

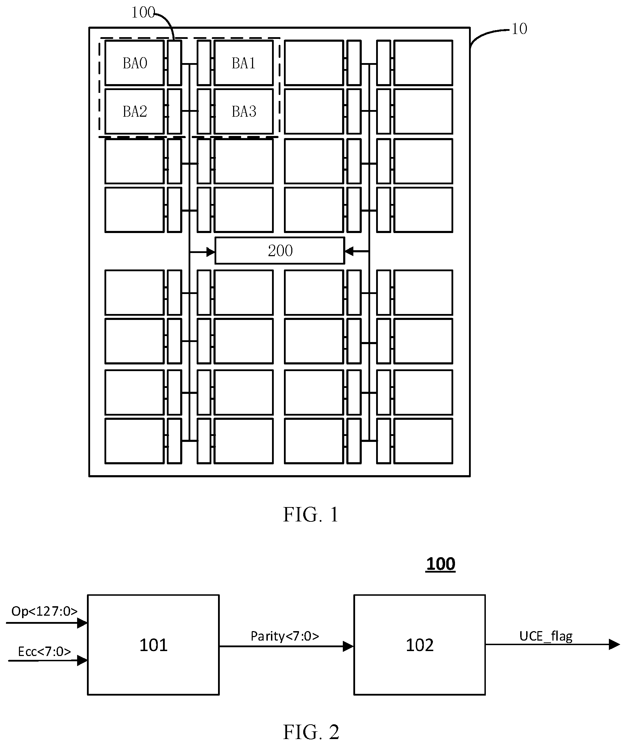

In an embodiment of the present disclosure, referring to FIG. 1, which is a schematic diagram of a compositional structure of a memory 10 according to an embodiment of the present disclosure. As shown in FIG. 1, the memory 10 includes: multiple banks, each of the banks including multiple data memory array tiles and an ECC memory array tile; multiple error checking circuits 100 having a one-to-one correspondence with the multiple banks; each of the error checking circuits being configured to respectively read stored data and check data from the multiple data memory array tiles and the ECC memory array tile of the corresponding bank, and generate a corresponding error checking signal based on the stored data and the check data, the error checking signal being configured to indicate whether an error meeting a condition occurs on the stored data and/or the check data of the corresponding bank; and an error address generation circuit 200, configured to receive the multiple error checking signals from the multiple error checking circuits, and store, into a mode register for storage, address information corresponding to an error failing to meet a condition when any one of the error checking signals is at an inactive level. The address information includes error row address information and error column address information.

As shown in FIG. 1, the memory 10 includes multiple banks, and each of the banks includes multiple data memory array tiles and an ECC memory array tile (not shown in the figure). For a DRAM, multiple banks may be classified into multiple bank groups (Bank Group, BG) according to an operation requirement, and each of the bank groups includes several banks (Bank, BA). For example, for a memory 10 with 32 banks, when the memory 10 is in an X4/X8 operation mode, the memory 10 may be divided into eight bank groups, and each of the bank groups includes four banks (as shown in a dashed line box in the figure, one bank group may include four banks: BA0, BA1, BA2, and BA3). Each of the banks may be divided into multiple sections (section) in a layout manner. Each of the sections includes multiple memory array tiles (memory array tile, MAT) and at least one ECC memory array tile (ECC mat). Each of the memory array tiles is configured to store data, and each of the ECC memory array tile is configured to store check data. Each of the banks has one corresponding on-die ECC computing module, which is configured to compute, according to a preset algorithm, stored data read from the bank. If the stored data read from the bank is not consistent with the check data read from the ECC memory array tile through computing and comparison, it indicates that an error occurs. If the error is a 1-bit error, the on-die ECC can correct the error. However, an error with two or more bits cannot be corrected because a check capability of the on-die ECC is insufficient. It should be explained that the check capability of the on-die ECC is determined jointly by a quantity of bits of a check code and an encoding manner. For an on-die ECC employing a Hamming code encoding manner, a check code with N bits (bits) may be configured to perform 1-bit error correction on data with 2^N-1 bits. An 8-bit check code is taken as an example. 2^8-1=255, that is, an 8-bit check code may be configured to perform 1-bit error correction on 255-bit data. For 128-bit data, 2^7-1=127<128<2^8-1. Therefore, an 8-bit ECC check code also needs to be provided to implement 1-bit check and correction. For an error with two or more bits, if the on-die ECC manner is employed to correct the error, more check codes need to be set, an ECC encoding circuit is more complex, and an ECC computing module occupies more memory space, which is not conducive to improving an integration level of the memory.

Specifically, when the error checking signal is at an active level, it indicates that an error meeting a condition occurs on the stored data and/or the check data of the corresponding bank. However, when the error checking signal is at an inactive level, it indicates that an error failing to meet a condition occurs on the stored data and/or the check data of the corresponding bank.

The multiple error checking circuits 100 may be disposed in a peripheral proximity area of the bank, and may be configured to receive stored data read from a corresponding bank and check data read from a corresponding ECC memory array tile. If an error correctable by the on-die ECC, that is, an error with one or less bit, occurs on the stored data and/or the check data, it means that an error meeting a condition occurs, and the error checking circuit 100 generates an error checking signal at an active level. If an error uncorrectable by the on-die ECC, that is, an error with two or more bits, occurs on the stored data and/or the check data, it means that an error failing to meet a condition occurs, and the error checking circuit 100 generates an error checking signal at an inactive level. A quantity of the multiple error checking circuits 100 herein may be in a one-to-one correspondence with a quantity of banks, that is, each bank corresponds to one error checking circuit 100. In this way, the on-die ECC may be employed to pre-identify a possible error in the memory 10. For an error meeting a condition, an error checking signal at an active level is generated. For an error failing to meet a condition, an error checking signal at an inactive level is generated. The inactive level may be a high level or a logic 1, and the active level may be a low level or a logic 0. As shown in FIG. 1, the error checking circuit 100 may be disposed in a peripheral area on a left side or a right side of the bank, so that the stored data read from the bank and the check data read from the ECC memory array tile can be received most quickly, thereby avoiding false identification of an error caused by data inversion on a long data bus, and improving accuracy of error identification.

The error address generation circuit 200 may be disposed in a middle area of the memory 10, and may be configured to receive address information, and store, into the mode register, address information corresponding to an error failing to meet a condition in response to any error checking signal. The error address generation circuit 200 herein is configured to receive error checking signals generated by multiple error checking circuits 100. If any one of the error checking signals is at an inactive level, that is, the error checking signal is active, indicating that an error uncorrectable by the on-die ECC occurs on the memory 10, the error address generation circuit 200 stores address information corresponding to the error. In this way, address information corresponding to a pre-identified error uncorrectable by the on-die ECC may be recorded in a timely manner. This helps a memory controller subsequently correct the error based on check data stored in an external ECC chip, thereby improving accuracy of the memory. The error address generation circuit 200 is disposed in the middle area of the memory 10, so that delays of arriving at the error address generation circuit 200 by the error checking signals transmitted from the banks on the left and right sides of the memory 10 can be consistent, thereby avoiding false identification of an error.

In some embodiments, the address information corresponding to the error failing to meet a condition is stored into a reserved for future use (Reserved for future use, RUF) mode register, and the memory controller may read the address information corresponding to the error from the mode register of the memory by employing a mode register read (Mode Register Read, MRR) or mode register set (Mode Register Set, MRS) command. In some other embodiments, a specific register may alternatively be newly added to the memory to store address information corresponding to a detected error failing to meet a condition, which is not specifically limited herein.

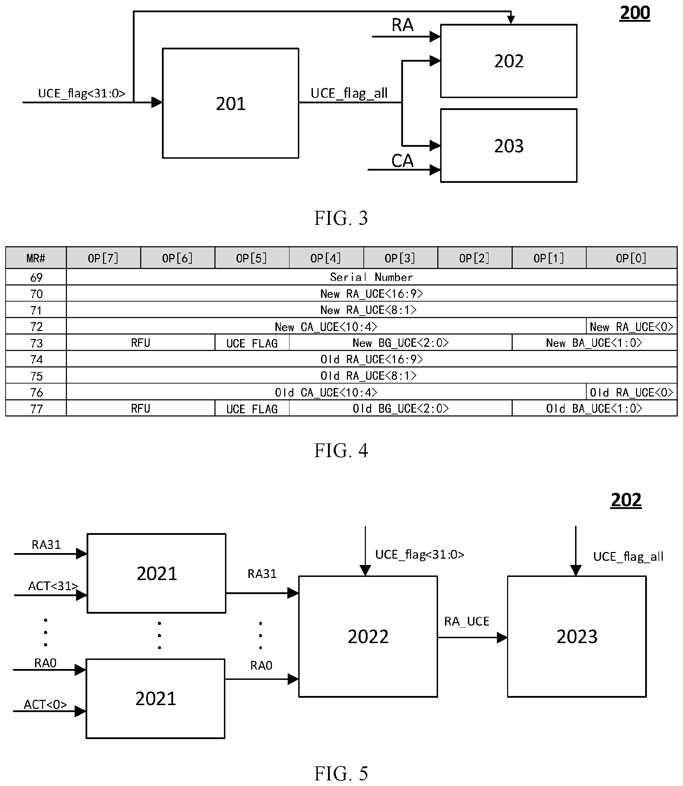

In some embodiments, as shown in FIG. 4, the error column address information further includes error bank group information (BG<2:0>) and error bank information (BA<1:0>). Because a CA address carried in a read command includes all of bank group information, bank information, and column address information, in the present disclosure, the bank group information (BG<2:0>), the bank information (BA<1:0>), and the column address information (CA<10:4>) are received, latched, and stored together as column address information. In some other embodiments, the bank group information and the bank information may alternatively be separately processed based on error checking information, which is not specifically limited herein.

In an embodiment of the present disclosure, referring to FIG. 2 and FIG. 4, the error address generation circuit 200 is further configured to generate and store error identification information UCE FLAG when any one of the error checking signals is at an inactive level. The error identification information UCE FLAG is configured to indicate whether an error failing to meet a condition occurs on stored data and/or check data corresponding to the address information stored in the error address generation circuit 200.

Specifically, the error identification information UCE FLAG is configured to mark whether an error failing to meet a condition occurs on the stored data and/or the check data corresponding to the address information (RA_UCE/CA_UCE/BG_UCE/BA_UCE) stored in the error address generation circuit 200. The external memory controller reads the address information (RA _UCE/CA_UCE/BG_UCE/BA_UCE) stored in the error address generation circuit 200 by employing a read command (e.g., a mode register read command MRR). However, the memory controller does not know whether the read address information (RA _UCE/CA_UCE/BG_UCE/BA_UCE) is the error address information corresponding to the error failing to meet a condition. Therefore, when the memory controller reads the address information (RA_UCE/CA_UCE/BG_UCE/BA_UCE) stored in the error address generation circuit, the corresponding error identification information UCE FLAG stored in the error address generation circuit 200 is also read. When the error identification information UCE FLAG is at a first level, an error failing to meet a condition occurs on data of the corresponding address information (RA_UCE/CA_UCE/BG_UCE/BA_UCE), and the memory controller performs error checking/correction based on the check data in the ECC chip. When the error identification information UCE FLAG is at a second level, no error failing to meet a condition occurs on data of the corresponding address information (RA_UCE/CA_UCE/BG_UCE/BA_UCE), and the memory controller does not need to perform error checking/correction processing. The first level may be a high level or a logic 1, and the second level may be a low level or a logic 0, which is not specifically limited herein.

It should be noted that, as shown in FIG. 4, each mode register may store eight data bits (OP<7:0>), and correspondingly store eight bits of address information or other information. Specifically, the mode register MR70-73 records NEW RA_UCE <16:0>/NEW CA_UCE <10:4>/NEW BG_UCE <2:0>/NEW BA_UCE <1:0> and the mode register MR74-77 records OLD RA_UCE <16:0>/OLD CA_UCE <10:4>/OLD BG_UCE <2:0>/OLD BA_UCE <1:0>, which respectively indicate two pieces of address information corresponding to two times of data reading on which an error failing to meet a condition occurs. NEW and OLD are only configured to distinguish between two pieces of address information. Alternatively, (RA1_UCE <16:0>/CA1_UCE <10:4>/BG1_UCE <2:0>/BA1_UCE <1:0>) and (RA0_UCE <16:0>/CA0_UCE <10:4>/BG0_UCE <2:0>/BA0_UCE <1:0>) may be employed for distinguishing. This is not limited herein. In addition to the address information, the mode register MR70-73 and the mode register MR74-77 separately record corresponding error identification information UCE FLAG, so as to identify whether an error failing to meet a condition occurs on stored data and check data corresponding to the address information stored in the corresponding mode register. In addition, a Serial Number recorded in the mode register MR69 is configured to indicate an amount of address information, stored in the memory, on which an error failing to meet a condition occurs. For example, if only two pieces of address information on which an error failing to meet a condition occurs can be stored in the memory, Serial Number=2.

In an embodiment of the present disclosure, referring to FIG. 2, which is a schematic diagram of a compositional structure of an error checking circuit 100 according to an embodiment of the present disclosure. As shown in FIG. 2, the error checking circuit 100 includes: a first checking circuit 101, configured to receive the stored data OP<127:0> and the check data ECC<7:0>, and compare a check code generated based on the stored data OP<127:0> with the check data ECC<7:0> to generate a comparison result Parity<7:0>; and a first determining circuit 102, configured to receive the comparison result Parity<7:0> and determine whether the comparison result meets a condition, and generate the error checking signal UCE_flag at an active level when the comparison result meets the condition, or generate the error checking signal UCE_flag at an inactive level when the comparison result does not meet the condition.

The first checking circuit 101 may include a multi-stage exclusive OR gate, which is configured to receive the stored data OP<127:0> read from the bank and the check data ECC<7:0> read from the ECC memory array tile, and compare a check code generated based on the stored data OP<127:0> with the check data ECC<7:0> to generate a comparison result Parity<7:0>. Herein, the stored data being 128 bits and the check data being 8 bits are taken as an example. A 7-stage exclusive OR gate may be configured to receive the stored data OP<127:0>, perform an exclusive OR operation to generate an 8-bit check code, and then compare the check data ECC<7:0> with the check code to generate a comparison result Parity<7:0>.

The first determining circuit 102 is configured to receive the comparison result Parity<7:0> generated by the first checking circuit 101 and determine whether the comparison result meets a condition, and generate the error checking signal UCE_flag at an active level when the comparison result meets the condition, or generate the error checking signal UCE_flag at an inactive level when the comparison result does not meet the condition. Specifically, it may be first determined whether the comparison result Parity<7:0> meets a first condition. The first condition herein may be whether the comparison result Parity<7:0> is all 0 (=00000000). If the comparison result Parity<7:0> is all 0, it indicates that a check code generated by computing the stored data OP<127:0> is consistent with the check data ECC<7:0>. In other words, no error occurs on the bank. In this case, an error checking signal UCE_flag at an active level is generated. Otherwise, it indicates that the check code generated by computing the stored data OP<127:0> is inconsistent with the check data ECC<7:0>. In other words, an error occurs on the bank. In this case, the first determining circuit 102 continues to determine whether the comparison result Parity<7:0> meets a second condition. The second condition herein may be that an error occurs on one bit of the 128-bit stored data OP<127:0> or an error occurs on one bit of the 8-bit check data ECC<7:0>. Because all errors herein are errors correctable by the on-die ECC, an error checking signal UCE_flag at an active level is generated. Otherwise, it indicates that an error occurs on two or more bits of the check code generated by computing the stored data OP<127:0> and/or the check data ECC. In other words, an error uncorrectable by the on-die ECC occurs on the bank. In this case, an error checking signal UCE_flag at an inactive level is generated.

The first determining circuit 102 may be formed by a multi-stage logic circuit operation, e.g., a NAND gate or an exclusive OR gate. A specific circuit of the first determining circuit 102 is in a one-to-one correspondence with the first condition and the second condition. A person skilled in the art should understand that when different ECC computing encoding manners are employed, the corresponding first condition and second condition also vary. Therefore, an implementation circuit of the first determining circuit 102 also varies. This embodiment of the present disclosure sets no limitation on the specific circuit of the first determining circuit 102.

It should be noted that, there is a special case that when an error occurs on two or more bits of the stored data and/or the check data, but superimposed codes at the multiple error locations still correspond to one error location, the on-die ECC considers that an error occurs on one bit of the stored data and/or the check data in this case. In other words, missed identification of an error failing to meet a condition occurs. To improve the probability of correct identification of an error, an encoding matrix of the on-die ECC may be modified to avoid occurrence of this case as far as possible. A specific implementation of the encoding matrix of the on-die ECC is not discussed much in this embodiment of the present disclosure.

In an embodiment of the present disclosure, referring to FIG. 3 and FIG. 4, which are schematic diagrams of a compositional structure of an error address generation circuit 200 according to an embodiment of the present disclosure. As shown in FIG. 3, the error address generation circuit 200 includes: a combining circuit 201, configured to receive the multiple error checking signals UCE_flag<31:0> corresponding to the multiple banks, and combine the multiple error checking signals to generate an error checking total signal UCE_flag_all, where when any one of the error checking signals UCE_flag is at an inactive level, the generated error checking total signal UCE_flag_all is at an inactive level; a row address generation circuit 202, configured to receive the multiple error checking signals UCE_flag<31:0> and the error checking total signal UCE_flag_all, and when any one of the error checking signals UCE_flag is at an inactive level, output row address information of the corresponding bank as error row address information (RA _UCE), and store the error row address information (RA_UCE) in response to the error checking total signal UCE_flag_all at an inactive level; and a column address generation circuit 203, configured to store error column address information (CA_UCE/BG_UCE/BA_UCE) corresponding to an error failing to meet a condition in response to the error checking total signal at an inactive level.

Each bank is corresponding to one error checking circuit 100, and a corresponding error checking signal UCE_flag is generated. As shown in FIG. 1, when one memory 10 includes 32 banks, 32 error checking signals UCE _flag<31:0> are correspondingly generated. To reduce space occupied by the error address generation circuit 200 in the memory 10, a combining circuit 201 may be disposed and be configured to receive multiple error checking signals UCE_flag<31:0> corresponding to multiple banks, and combine the multiple error checking signals to generate an error checking total signal UCE_flag_all. When any error checking signal UCE_flag is at an inactive level, that is, when an error uncorrectable by the on-die ECC occurs on any bank, the error checking total signal UCE_flag_all generated by the combining circuit 201 is also at an inactive level, so that a subsequent row address generation circuit 202 and column address generation circuit 203 may be enabled to respectively store row address information and column address information that correspond to the error.

In some embodiments, the combining circuit 201 may be a multi-input OR gate. An input terminal of the OR gate receives multiple error checking signals UCE_flag<31:0>, and an output terminal of the OR gate outputs an error checking total signal UCE_flag_all.

The row address generation circuit 202 may select received row address information RA in response to the multiple error checking signals UCE_flag<31:0>, generate error row address information, and store the error row address information into a corresponding mode register in response to the error checking total signal UCE_flag_all. However, the column address generation circuit 203 directly stores the corresponding error column address information into the corresponding mode register in response to the error checking total signal UCE_flag_all.

It should be noted that, for the row address information RA and the column address information CA, based on a DRAM truth table, the row address information RA is obtained by decoding a command/address signal corresponding to an activation command, and the column address information CA is obtained by decoding a command/address signal corresponding to a read command. The error checking signal UCE_flag is generated through a logic operation performed by the error checking circuit 100 after the memory 10 receives the read command. Therefore, the received address information RA/CA needs to be selected or delayed in reading by employing multiple error checking signals UCE_flag<31:0>, so as to ensure that the currently occurring error has an accurate correspondence with the stored error row address information and error column address information. Specifically, as shown in FIG. 3, in the row address generation circuit 202, multiple error checking signals UCE_flag<31:0> further need to be configured to select multiple pieces of row address information RA that are received in parallel, so as to avoid a case that when cross-reading/writing is performed, that is, when the memory 10 has not finished performing a read operation on one bank, an activation operation is performed simultaneously on another bank, and consequently, row address information RA corresponding to a next activation operation responding to a current error checking total signal UCE_flag_all is falsely identified by the error address generation circuit 200. Both the column address information CA and the error checking signal UCE_flag are generated according to the read command, and delays of the column address information CA and the error checking signal UCE_flag have a fixed correspondence. Reading corresponding column address information through delaying leads to a relatively low possibility of false identification. Therefore, the received column address information CA may be directly read through delaying as the error column address information. For the mode register, as long as any error checking signal UCE_flag is at an inactive level, that is, an error uncorrectable by the on-die ECC occurs on any bank, address information corresponding to the error is stored into the mode register in response to the error checking total signal UCE_flag_all at an inactive level, thereby facilitating subsequent locating and correction of the error.

In some embodiments, the column address generation circuit 203 may also be designed in a similar manner to the row address generation circuit 202. To be specific, the column address generation circuit 203 also selects the received column address information CA in response to the multiple error checking signals UCE_flag<31:0>, generates the error column address information, and stores the error column address information into a corresponding mode register in response to the error checking total signal UCE_flag_all. In an embodiment of the present disclosure, referring to FIG. 5, which is a schematic diagram of a compositional structure of a row address generation circuit 202 according to an embodiment of the present disclosure. As shown in FIG. 4, the row address generation circuit 202 includes: multiple row address latch circuits 2021 having a one-to-one correspondence with the multiple banks, each of the row address latch circuits 2021 being configured to latch, in response to an activation signal ACT<31> of the corresponding bank, row address information RA31 corresponding to the activation signal ACT<31>; a row address selection circuit 2022, configured to receive the multiple error checking signals UCE_flag<31:0> and multiple pieces of row address information RA31-RA0 latched by the multiple row address latch circuits 2021, and when any one of the error checking signals UCE_flag is at an inactive level, output corresponding row address information RA as error row address information RA_UCE; and a row address storage circuit 2023, configured to store the error row address information RA_UCE in response to the error checking total signal UCE_flag_all at an inactive level.

As described above, the row address information RA and the activation signal ACT of the stored data are both obtained by decoding a command/address signal corresponding to the activation signal ACT. Therefore, to match a delay of the error checking signal UCE_flag, multiple row address latch circuits 2021 corresponding to the multiple banks may be disposed, and each of the row address latch circuits 2021 is configured to decode, in response to the corresponding activation signal ACT<31>, the command/address signal corresponding to the row address latch circuit to obtain row address information RA31 of the corresponding bank for latching. The row address selection circuit 2022 is configured to receive the multiple error checking signals UCE_flag<31:0> and multiple pieces of row address information RA31-RA0 latched by the multiple row address latch circuits 2021, and when any one of the error checking signals UCE_flag is at an inactive level, output corresponding row address information RA as error row address information RA_UCE. The row address selection circuit 2022 is configured to receive the multiple error checking signals UCE_flag<31:0> and multiple pieces of row address information RA31-RA0 latched by the multiple row address latch circuits 2021, and choose to generate error row address information RA_UCE based on the multiple error checking signals UCE_flag<31:0>. For example, when UCE_flag<30> in the multiple error checking signals UCE_flag<31:0> is at an inactive level, corresponding row address information RA31 is output as error row address information RA_UCE. An error checking signal UCE_flag corresponding to any bank is at an inactive level, indicating that an error uncorrectable by the on-die ECC occurs on the bank. Therefore, the row address selection circuit 2022 is enabled to choose to generate row address information corresponding to the bank, that is, the error row address information RA_UCE. The row address storage circuit 2023 receives the error row address information RA_UCE generated by the row address selection circuit 2022, and stores the error row address information RA_UCE into the corresponding mode register in response to the error checking total signal UCE_flag_all at an inactive level. It should be noted that, as shown in FIG. 4, the mode register corresponding to the row address information herein may be a preset redundant mode register in the memory, for example, may be mode registers MR70 to MR72. The three mode registers are configured to store 17-bit error row address information, and each of the mode registers may store 8 bits.

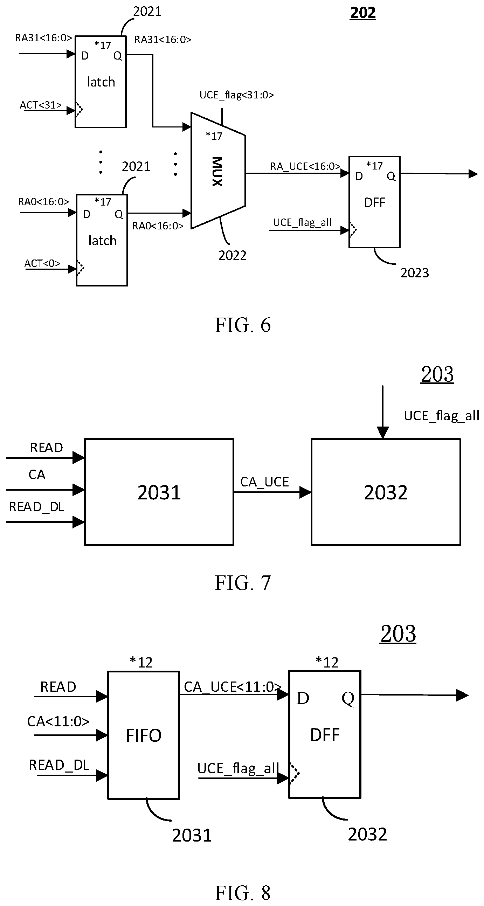

In some embodiments, referring to FIG. 6, which is a schematic circuit diagram of a row address generation circuit 202 according to an embodiment of the present disclosure. As shown in FIG. 6, each row address latch circuit 2021 may include one group of latches. A data input terminal of each latch receives one bit of data in one group of row address signals RA<16:0> of the corresponding bank, and a clock terminal of each latch receives one activation signal ACT31 of the corresponding bank (herein, a group of latches included in a row address latch circuit 2021 corresponding to a 32nd bank are employed for description), and latches, in response to the activation signal ACT31, one bit of data in row address information RA31<16:0> corresponding to the corresponding bank BA<31>. Therefore, a quantity of the group of latches included in the row address latch circuit 2021 may be set to be the same as a quantity of bits of the row address information RA<16:0> of the bank, and each bit of data in the row address information RA<16:0> is latched one by one.

As shown in FIG. 6, the row address selection circuit 2022 is configured to receive the multiple error checking signals UCE_flag<31:0> and multiple pieces of row address information RA31-RA0 latched by the multiple row address latch circuits 2021, and choose to generate error row address information RA_UCE based on the multiple error checking signals UCE_flag<31:0>. For example, when UCE_flag<30> in the multiple error checking signals UCE_flag<31:0> is at an inactive level, corresponding row address information RA31 is output as error row address information RA_UCE. Still referring to FIG. 6, the row address selection circuit 2022 may include a group of (17) selectors. Multiple (32) input terminals of each selector are respectively configured to receive one bit of data that has the same location in multiple (32) pieces of row address information RA31-RA0 latched by the multiple (32) row address latch circuits 2021. For example, a first selector MUX separately receives RA0<0>...RA31<0>, a second selector MUX separately receives RA0<1>...RA31<1>, and so on. A control terminal of each selector MUX receives multiple error checking signals UCE_Flag<31:0> corresponding to the multiple banks. If an error failing to meet a condition, that is, an error uncorrectable by the on-die ECC occurs on any bank, an error checking signal UCE_flag corresponding to the bank is at an inactive level (UCE_flag=1). In this case, the selector is controlled to output 1-bit row address information corresponding to the bank. Therefore, a group of (17-bit) row address information that is correspondingly output by a group of selectors MUX included in the row address selection circuit 2022 is denoted as error row address information RA_UCE<16:0>. Still referring to FIG. 6, the row address storage circuit 2023 may include a group of (17) flip-flops. A data input terminal of each flip-flop receives one bit of the error row address information RA_UCE<16:0>, and a clock terminal of the flip-flop receives the error checking total signal UCE_flag_all, and is configured to store one bit of the error row address information RA_UCE<16:0> into the corresponding mode register in response to the error checking total signal UCE_flag_all at an inactive level. The group of (17) flip-flops included in the row address storage circuit 2023 store 17 bits of the error row address information RA _UCE<16:0> into the corresponding mode register in parallel. It should be noted that a quantity of the group of flip-flops herein corresponds to multiple bits in the mode register, and every eight flip-flops form one mode register. For example, the error row address information RA_UCE<16:0> includes 17 bits, and in this case, 17 flip-flops are needed to form three 8-bit (capacity) mode registers to store the error row address information. For brevity of illustration, only one latch and one flip-flop are shown in the accompanying drawings. In an actual circuit, a memory includes 32 banks, and row address information RA includes 17-bit data. A row address latch circuit 2021 may include 32 groups of latches, and each group includes 17 latches corresponding to 17-bit data of row address signals RA<16:0>. A row address selection circuit 2022 also includes 32 groups of selectors, and each group includes 17 selectors corresponding to 17-bit data of the row address signals RA<16:0>. A row address storage circuit 2023 may include 17 flip-flops corresponding to 17-bit data of error row address signals RA_UCE<16:0>.

In an embodiment of the present disclosure, referring to FIG. 7, which is a schematic diagram of a compositional structure of a column address generation circuit 203 according to an embodiment of the present disclosure. As shown in FIG. 7, the column address generation circuit 203 includes: a column address latch circuit 2031, configured to input, in response to a read signal, column address information corresponding to the signal into a buffer, and output, in response to a read delay signal, the column address information corresponding to the read signal from the buffer as error column address information; the read delay signal being a delay signal of the read signal; and a column address storage circuit 2032, configured to store the error column address information into a corresponding mode register in response to the error checking total signal at an inactive level.

As described above, because the column address information CA of the stored data is obtained by decoding a command/address signal corresponding to the read command, the column address latch circuit 2031 may be disposed to: decode the command/address signal in response to the read signal READ to obtain corresponding column address information CA, and input the corresponding column address information CA into the buffer; and output, in response to the read delay signal READ_DL, the column address information CA corresponding to the read signal READ from the buffer as error column address information CA_UCE. It may be understood that, in a process of reading data by a DRAM, there is a delay in each of the following: a command/address signal decoder obtains a read signal READ through decoding; stored data is read from a bank; and the stored data is transmitted to a data port. The read delay signal READ_DL is a read signal READ that is obtained after these delays are matched. The error checking signal UCE_flag and the error checking total signal UCE_flag_all also need to undergo these delays. Therefore, the read delay signal READ_DL may be employed as an output trigger signal of the column address latch circuit 2031, so that the error checking signal UCE_flag and the error checking total signal UCE_flag_all can match the error column address information CA_UCE released from the column address latch circuit 2031. Therefore, the error column address information CA_UCE herein does not need to be selected, and is the column address information CA received by the column address latch circuit 2031.

The column address storage circuit 2032 receives the error column address information CA_UCE that is output by the column address latch circuit 2031, and stores the error column address information CA_UCE into the corresponding mode register in response to the error checking total signal UCE_flag_all at an inactive level.

In some embodiments, the error column address information CA_UCE<11:0> includes 7-bit column address information CA<10:4>, 3-bit bank group address information BG<2:0>, and 2-bit bank address information BA<1:0>. Therefore, preset redundant mode registers such as MR72 and MR73 in the memory may be employed, as shown in FIG. 4. The two mode registers are configured to store 12-bit error column address information CA _UCE<12:0>, where the error column address information CA_UCE<11:0> may share the mode register MR72 with the error row address information RA_UCE<16:0>.

In some embodiments, referring to FIG. 8, which is a schematic circuit diagram of a column address generation circuit 203 according to an embodiment of the present disclosure. As shown in FIG. 8, the column address latch circuit 2031 may include multiple first in first out buffers FIFO. A data input terminal of each of the first in first out buffers receives column address information CA (not shown in the figure) generated by decoding a command/address signal corresponding to a read command, an input clock terminal receives a read signal READ and is configured to input corresponding column address information CA into the first in first out buffer in response to the read signal READ, and an output clock terminal receives a read delay signal READ_DL and is configured to output error column address information CA _UCE<11:0> from the first in first out buffer in response to the read delay signal READ_DL. Because a delay from the read signal READ to the read delay signal READ_DL is affected by a column access gating delay tAA, during this delay, the memory 10 may receive a next read command, and a column address correspondingly changes in this case. To store a column address corresponding to each read command, a first in first out buffer may be disposed, and a depth of the first in first out buffer meets the following condition: depth = t(READ to READ_DL)/teeds. For example, the depth of the first in first out buffer may be set to 10. A quantity of first in first out buffers is kept consistent with a quantity of bits of the error column address information CA_UCE<11:0>, and may be 12. Each of the first in first out buffers correspondingly receives and outputs one-bit column address information.

The column address storage circuit 2032 may include multiple flip-flops. A data input terminal of each of the flip-flops receives the error column address information CA_UCE<11:0>, and a clock terminal of the flip-flop receives the error checking total signal UCE_flag_all and is configured to store the error column address information CA_UCE<11:0> into the corresponding mode register in response to the error checking total signal UCE_flag_all at an inactive level. Similarly, the multiple flip-flops herein correspond to multiple bits in the mode register. For example, the error column address information CA_UCE<11:0> includes 12 bits, and in this case, 12 flip-flops and two 8-bit (capacity) mode registers are needed to store the error column address information. For brevity of illustration, only one flip-flop is shown in the accompanying drawings. In an actual circuit, the column address storage circuit 2032 may include 12 flip-flops corresponding to 12-bit data of the error column address information CA _UCE<11:0>.

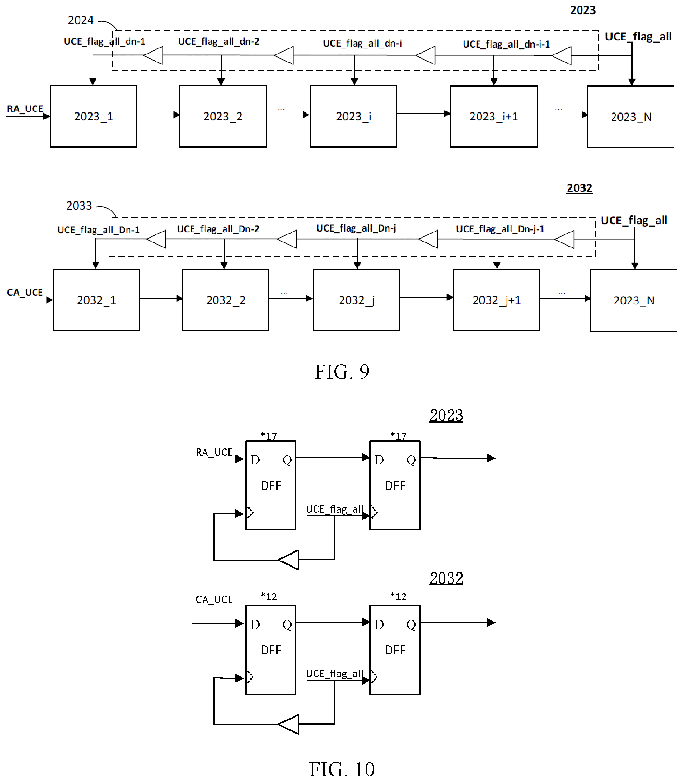

In an embodiment of the present disclosure, referring to FIG. 9, which is a schematic diagram of a compositional structure of a row address storage circuit 2023 and a column address storage circuit 2032 according to an embodiment of the present disclosure. As shown in FIG. 9, the row address storage circuit 2023 includes N serially connected row address storage subcircuits. A 1st row address storage subcircuit 2023_1 is configured to store received error row address information when an error checking total signal UCE_flag_all_dn-1 on which a first delay is performed for N-1 times is at an inactive level. An ith row address storage subcircuit 2023_i is configured to receive and store error row address information stored in an (i-1)th row address storage subcircuit 2023_i-1, when an error checking total signal UCE_flag_all_dn-i on which a first delay is performed for N-1 times is at an inactive level. An Nth row address storage subcircuit 2023_N is configured to receive and store error row address information stored in an (N-1)th row address storage subcircuit 2023_N-1, when the error checking total signal UCE_flag_all is at an inactive level. The first delay is several clock cycles, N is greater than or equal to 2, and i is a positive integer greater than 1 and less than N. A 1st column address storage subcircuit 2032_1 is configured to store received error column address information when an error checking total signal UCE_flag_all_Dn-1 on which a second delay is performed for N-1 times is at an inactive level. A jth column address storage subcircuit 2032_j is configured to receive and store error column address information stored in a (j-1)th column address storage subcircuit 2032_j, when an error checking total signal UCE_flag_all_Dn-j on which a second delay is performed for N-j times is at an inactive level. An Nth column address storage subcircuit 2032_N is configured to receive and store error column address information stored in an (N-1)th column address storage subcircuit, when the error checking total signal UCE_flag_all is at an inactive level. The second delay is several clock cycles, and j is a positive integer greater than 1 and less than N.

In the row address storage circuit 2023, N serially connected row address storage subcircuits may be disposed. A first row address storage subcircuit may store the error row address information RA_UCE corresponding to the current error into the corresponding mode register in response to the error checking total signal UCE_flag_all at an inactive level. To distinguish a previous error from a currently occurring error, an error checking total signal UCE_flag_all_dn-i received by an ith row address storage subcircuit 2023_i may be set to be delayed by several clock cycles compared with an error checking total signal UCE_flag_all_dn-i-1 received by an (i+1)th row address storage subcircuit 2023_i+1, where N is greater than or equal to 2. In this way, an error checking total signal that is employed by each row address storage subcircuit for response and storage varies, and is delayed by several clock cycles compared with a previous error checking total signal. In this way, address information corresponding to N errors is separately stored. The storage device may read address information corresponding to multiple errors through multiple rounds of mode register read command, and perform error correction on the address information.

In some embodiments, still referring to FIG. 9, the row address storage circuit 2023 further includes a first delay chain 2024. The first delay chain is configured to successively perform a first delay on the error checking total signal for multiple times to generate multiple delayed error checking total signals, where the first delay is several clock cycles. Specifically, the first delay chain 2024 performs a first delay on a received error checking total signal for N-1 times, and one corresponding delayed error checking total signal is generated and output for each delay. For example, a delayed error checking total signal generated after the first delay chain 2024 performs a first delay on the error checking total signal once is sent to an (N-1)th row address storage subcircuit, and a delayed error checking total signal generated after the first delay chain performs a first delay on the error checking total signal twice is sent to an (N-2)th row address storage subcircuit. By analogy, a delayed error checking total signal generated after the first delay chain performs a first delay on the error checking total signal for N-1 times is sent to the first row address storage subcircuit.

It should be noted that the first delay is successively performed for N-1 times to ensure that an error checking total signal received by each row address storage subcircuit is delayed by several clock cycles compared with a previous error checking total signal. A specific quantity of clock cycles of the first delay may be implemented by adjusting a parameter of a buffer in a delay chain according to a requirement, which is not specifically limited herein.

In some embodiments, still referring to FIG. 9, the column address storage circuit 2032 further includes a second delay chain 2033. The second delay chain 2033 is configured to successively perform a second delay on the error checking total signal for multiple times to generate multiple delayed error checking total signals, where the second delay is several clock cycles. Specifically, the second delay chain performs a second delay on a received error checking total signal for N-1 times, and one corresponding delayed error checking total signal is generated and output for each delay. For example, a delayed error checking total signal generated after the second delay chain 2033 performs a second delay on the error checking total signal once is sent to an (N-1)th column address storage subcircuit, and a delayed error checking total signal generated after the second delay chain performs a second delay on the error checking total signal twice is sent to an (N-2)th column address storage subcircuit. By analogy, a delayed error checking total signal generated after the second delay chain performs a second delay on the error checking total signal for N-1 times is sent to the first column address storage subcircuit.

It should be noted that the second delay is successively performed for N-1 times to ensure that an error checking total signal received by each column address storage subcircuit is delayed by several clock cycles compared with a previous error checking total signal. A specific quantity of clock cycles of the second delay may be implemented by adjusting a parameter of a buffer in a delay chain according to a requirement. In addition, the second delay and the first delay may be set to the same quantity of clock cycles, and the second delay and the first delay may alternatively be set to different quantities of clock cycles. This is not specifically limited herein.

In some embodiments, referring to FIG. 10, which is a schematic circuit diagram of a row address storage circuit 2023 and a column address storage circuit 2032 according to an embodiment of the present disclosure. As shown in FIG. 10, the row address storage circuit 2023 may include two groups of serially connected flip-flops (one group of serially connected flip-flops may serve as one row address storage subcircuit), and each group of flip-flops includes 17 parallel flip-flops. A data input terminal of each flip-flop in the first group of flip-flops receives 17-bit data of error row address signals RA_UCE<16:0>, and a clock terminal receives a delay signal of the error checking total signal UCE_flag_all. An output terminal of each flip-flop in the first group of flip-flops is connected to a data input terminal of one corresponding flip-flop in the second group of flip-flops. A clock terminal of each flip-flop in the second group of flip-flops receives the error checking total signal UCE_flag_all. The column address storage circuit 2032 may include two groups of serially connected flip-flops (one group of serially connected flip-flops may serve as one column address storage subcircuit), and each group of flip-flops includes 12 parallel flip-flops. A data input terminal of each flip-flop in the first group of flip-flops receives 12-bit data of error column address signals CA_UCE<11:0>, and a clock terminal receives a delay signal of the error checking total signal UCE_flag_all. An output terminal of each flip-flop in the first group of flip-flops is connected to a data input terminal of one corresponding flip-flop in the second group of flip-flops. A clock terminal of each flip-flop in the second group of flip-flops receives the error checking total signal UCE_flag_all. The row address storage circuit 2023 and the column address storage circuit 2032 with a depth of 2 (N=2) may be disposed to store two groups of error address information (each group of error address information includes error row address information RA_UCE and error column address information CA_UCE). The storage device may read, by employing multiple mode register read commands, two pieces of error information failing to meet a condition, thereby improving error correction efficiency.

It should be noted that when the row address storage circuit 2023 and the column address storage circuit 2032 each include N serially connected storage subcircuits, at least one flip-flop is needed. To be specific, at least one bit in the mode register is configured to store a value N (as shown in FIG. 4, eight flip-flops of the mode register MR69 are configured to store Serial Number), that is, record a specific quantity of pieces of error address information stored in the memory. In this way, the controller may determine, by reading a specific bit in the mode register, a specific quantity of pieces of error address information on which error correction needs to be performed in the memory. For example, the mode register MR69 OP<0>=0 indicates that error correction needs to be performed on one piece of error address information failing to meet a condition in the memory, and the mode register MR69 OP<0>=1 indicates that error correction needs to be performed on two pieces of error address information failing to meet a condition in the memory.

The memory 10 may further include a counting circuit, configured to count the error checking total signal UCE_flag_all, so as to record a quantity of times that an error failing to meet a condition occurs on the memory. The controller may perform error correction on the memory 10 by reading a value of the counting circuit.

An embodiment of the present disclosure further provides a memory operation method. A memory includes multiple banks, and each of the banks includes multiple data memory array tiles and an ECC memory array tile. The operation method includes the following steps: Stored data and check data that are respectively read from the multiple data memory array tiles and the ECC memory array tile of any one of the banks are received, and a corresponding error checking signal is generated based on the stored data and the check data. The error checking signal is configured to indicate whether an error meeting a condition occurs on the stored data and/or the check data of the corresponding bank. The error checking signal is received, and address information corresponding to an error failing to meet a condition when the error checking signal is at an inactive level. The address information includes error row address information and error column address information.

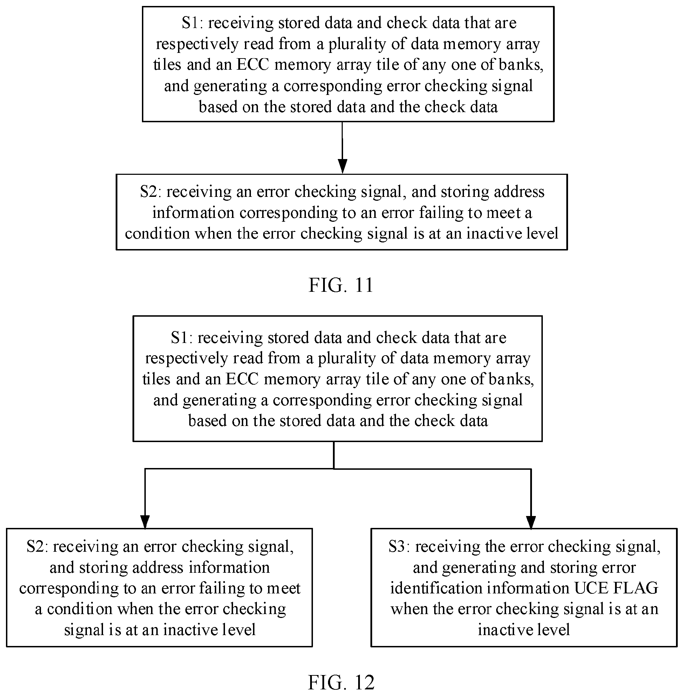

In an embodiment of the present disclosure, reference is made to FIG. 11, which is a schematic diagram of a procedure step of a memory operation method according to an embodiment of the present disclosure. As shown in FIG. 11, the operation method includes the following steps:
In the step of S1, stored data and check data that are respectively read from the multiple data memory array tiles and the ECC memory array tile of any one of the banks are received, and a corresponding error checking signal is generated based on the stored data and the check data; the error checking signal being configured to indicate whether an error meeting a condition occurs on the stored data and/or the check data of the corresponding bank.
In the step of S2, the error checking signal is received, and address information corresponding to an error failing to meet a condition is stored when the error checking signal is at an inactive level; the address information including error row address information and error column address information.

In some embodiments, with reference to FIG. 1 and FIG. 11, a specific process of step S1 includes the following steps: Each error checking circuit 100 receives stored data and check data that are respectively read from the multiple data memory array tiles and the ECC memory array tile of the corresponding bank, and generates a corresponding error checking signal based on the stored data and the check data. If an error meeting a condition occurs on the stored data and/or the check data, an error checking signal at an active level is generated. Otherwise, an error checking signal at an inactive level is generated.

In some embodiments, with reference to FIG. 1 and FIG. 11, a specific process of step S2 includes the following steps: The error address generation circuit 200 receives an error checking signal, and stores, when the error checking signal is at an inactive level, address information corresponding to an error failing to meet a condition into a mode register. The error address generation circuit 200 receives multiple error checking signals corresponding to the multiple error checking circuits 100. If any error checking signal is at an inactive level, it indicates that an error failing to meet a condition occurs on stored data and/or check data in a corresponding bank. In this way, the error address generation circuit 200 is enabled to store address information corresponding to the error failing to meet a condition into the mode register.

In this way, it may be detected whether an error meeting a condition occurs on a bank and/or an ECC memory array tile, and address information corresponding to an error failing to meet a condition may be stored into the mode register. In this way, an on-die ECC may be employed to pre-identify an error occurring in the memory, and after an error uncorrectable by the on-die ECC is identified, record error address information in a timely manner, thereby facilitating subsequent correction of the error and improving accuracy of the memory.

With reference to FIG. 1, FIG. 4, and FIG. 12, when step S2 is performed, the operation method further includes the following step:
In the step of S3, when the error checking signal UCE_flag is at an inactive level, error identification information UCE FLAG is generated and stored; the error identification information UCE FLAG being configured to indicate whether an error failing to meet a condition occurs on stored data and/or check data corresponding to the stored address information.

Herein, the error address generation circuit 200 is further configured to generate and store error identification information UCE FLAG when any error checking signal is at an inactive level, where the error identification information UCE FLAG is configured to mark whether an error failing to meet a condition occurs on the stored data and/or the check data corresponding to the address information (RA_ UCE/CA_UCE/BG_UCE/BA_UCE) stored in the error address generation circuit 200. The external memory controller reads the address information (RA_UCE/CA_UCE/BG_UCE/BA_UCE) stored in the error address generation circuit 200 by employing a read command (e.g., a mode register read command MRR). However, the memory controller does not know whether the read address information (RA_UCE/CA_UCE/BG_UCE/BA_UCE) is the error address information corresponding to the error failing to meet a condition. Therefore, when the memory controller reads the address information (RA_UCE/CA_UCE/BG_UCE/BA_UCE) stored in the error address generation circuit, the corresponding error identification information UCE FLAG stored in the error address generation circuit 200 is also read. When the error identification information UCE FLAG is at a first level, an error failing to meet a condition occurs on data of the corresponding address information (RA_UCE/CA_UCE/BG_UCE/BA_UCE), and the memory controller performs error checking/correction based on the check data in the ECC chip. When the error identification information UCE FLAG is at a second level, no error failing to meet a condition occurs on data of the corresponding address information (RA_UCE/CA_UCE/BG_UCE/BA_UCE), and the memory controller does not need to perform error checking/correction processing.

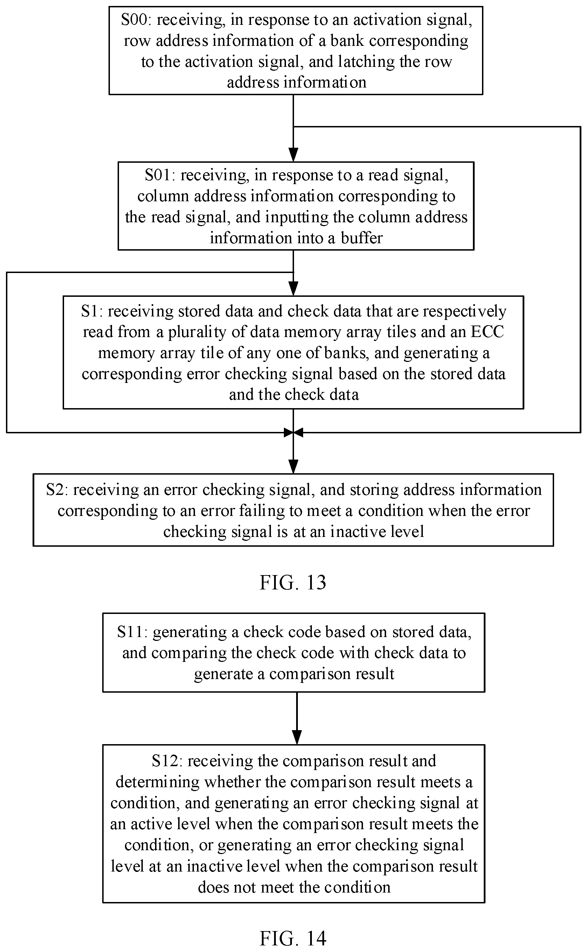

FIG. 13 is a schematic diagram of another procedure step of a memory operation method according to an embodiment of the present disclosure. As shown in FIG. 11, before receiving the stored data read from the corresponding bank and the check data read from the ECC memory array tile to generate the error checking signal, the operation method further includes the following steps:
In the step of S00, in response to an activation signal, row address information of a bank corresponding to the activation signal is received and latched.
In the step of S01, in response to a read signal, column address information corresponding to the read signal is received and input into a buffer.

In some embodiments, with reference to FIG. 4 and FIG. 13, a specific process of step S00 includes the following step: A row address latch circuit 2021 is configured to decode, in response to the activation signal ACT, a command/address signal corresponding to the activation signal ACT to obtain row address information RA of the bank for latching.

In some embodiments, with reference to FIG. 6 and FIG. 11, a specific process of step S01 includes the following step: A column address latch circuit 2031 is configured to decode, in response to the read signal READ, a command/address signal corresponding to the read signal READ to obtain column address information CA of the bank and input the column address information CA into a buffer.

The error checking signal is generated only after a logic operation is performed on the UCE_flag based on the stored data and/or the check data. Therefore, to match a delay of the error checking signal UCE_flag, the address information needs to be first latched, and then the address information corresponding to the error is selectively generated based on a potential of the error checking signal UCE_flag.

FIG. 14 is a schematic diagram of another procedure step of a memory operation method according to an embodiment of the present disclosure. As shown in FIG. 14, in the step of S1 of the operation method, the generating a corresponding error checking signal based on the stored data and the check data specifically includes the following steps:
In the step of S11, a check code is generated based on the stored data, and the check code is compared with the check data to generate a comparison result.
In the step of S12, the comparison result is received and it is determined whether the comparison result meets a condition. The error checking signal at an active level is generated when the comparison result meets the condition, or the error checking signal at an inactive level is generated when the comparison result does not meet the condition.

In some embodiments, with reference to FIG. 2 and FIG. 14, a specific process of step S11 includes the following steps: The first checking circuit 101 receives the stored data OP<127:0> and the check data ECC<7:0>, and compares a check code generated based on the stored data OP<127:0> with the check data ECC<7:0> to generate a comparison result Parity<7:0>.

In some embodiments, with reference to FIG. 2 and FIG. 14, a specific process of step S12 includes the following steps: The first determining circuit 102 receives the comparison result Parity<7:0> and determines whether the comparison result meets a condition, and generates the error checking signal UCE_flag at an active level when the comparison result meets the condition, or generates the error checking signal UCE_flag at an inactive level when the comparison result does not meet the condition. Specifically, it may be first determined whether the comparison result Parity<7:0> meets a first condition. The first condition herein may be whether the comparison result Parity<7:0> is all 0 (=00000000). If the comparison result Parity<7:0> is all 0, it indicates that a check code generated by computing the stored data OP<127:0> is consistent with the check data ECC<7:0>. In other words, no error occurs on the bank. In this case, an error checking signal UCE_flag at an active level is generated. Otherwise, it indicates that the check code generated by computing the stored data OP<127:0> is inconsistent with the check data ECC<7:0>. In other words, an error occurs on the bank. In this case, the first determining circuit 102 continues to determine whether the comparison result Parity<7:0> meets a second condition. The second condition herein may be that an error occurs on one bit of the 128-bit stored data OP<127:0> or an error occurs on one bit of the 8-bit check data ECC<7:0>. Because all errors herein are errors correctable by the on-die ECC, an error checking signal UCE_flag at an active level is generated. Otherwise, it indicates that an error occurs on two or more bits of the check code generated by computing the stored data OP<127:0> and/or the check data ECC. In other words, an error uncorrectable by the on-die ECC occurs on the bank. In this case, an error checking signal UCE_flag at an inactive level is generated.

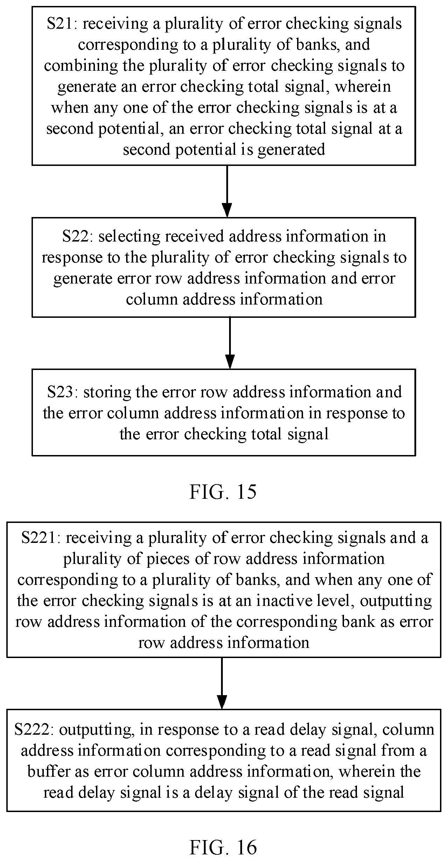

FIG. 15 is a schematic diagram of another procedure step of a memory operation method according to an embodiment of the present disclosure. As shown in FIG. 15, in the step of S2 of the operation method, the error checking signal is received, and address information corresponding to an error failing to meet a condition is stored when the error checking signal is at an inactive level, specifically including the following steps:
In the step of S21, multiple error checking signals corresponding to multiple banks are received and combined to generate an error checking total signal, where when any one of the error checking signals is at an inactive level, an error checking total signal at an inactive level is generated.
In the step of S22, the received address information is selected in response to the multiple error checking signals to generate error row address information and error column address information.
In the step of S23, the error row address information and the error column address information are stored in response to the error checking total signal.

In some embodiments, with reference to FIG. 3 and FIG. 15, a specific process of step S21 includes a combining circuit 201, configured to receive multiple error checking signals UCE_flag<31:0> corresponding to multiple banks, and combine the multiple error checking signals to generate an error checking total signal UCE_flag_all. When any error checking signal UCE_flag is at an inactive level, that is, when an error uncorrectable by the on-die ECC occurs on any bank, the error checking total signal UCE_flag_all generated by the combining circuit 201 is also at an inactive level.

In some embodiments, with reference to FIG. 3 and FIG. 15, a specific process of step S22 includes the following step: A row address generation circuit 202 and a column address generation circuit 203 are configured to select the received address information RA/CA in response to the multiple error checking signals UCE_flag<31:0> to generate error row address information and error column address information.

In some embodiments, with reference to FIG. 3 and FIG. 15, a specific process of step S23 includes the following step: The row address generation circuit 202 and the column address generation circuit 203 separately store the error row address information and the error column address information into the corresponding mode register in response to the error checking total signal UCE_flag_all. For the mode register, as long as any error checking signal UCE_flag is at an inactive level, that is, an error uncorrectable by the on-die ECC occurs on any bank, address information corresponding to the error is stored into the mode register in response to the error checking total signal UCE_flag at an inactive level, thereby facilitating subsequent locating and correction of the error.

FIG. 16 is a schematic diagram of another procedure step of a memory operation method according to an embodiment of the present disclosure. As shown in FIG. 16, in the step of S22 of the operation method, the received address information is selected in response to the multiple error checking signals to generate error row address information and error column address information, specifically including the following steps:
In the step of S221, the multiple error checking signals and multiple pieces of row address information corresponding to the multiple banks are received, and when any one of the error checking signals is at an inactive level, row address information of the corresponding bank is output as error row address information.
In the step of S222, in response to a read delay signal, the column address information corresponding to the read signal is output from the buffer as error column address information; the read delay signal being a delay signal of the read signal.

In some embodiments, with reference to FIG. 5 and FIG. 16, a specific process of step S221 includes the following steps: A row address selection circuit 2022 is configured to: receive multiple error checking signals UCE_flag<31:0> and multiple pieces of row address information RA31-RA0 corresponding to the multiple banks, and choose to generate error row address information RA_UCE based on the multiple error checking signals UCE_flag<31:0> corresponding to the multiple banks. An error checking signal UCE_flag corresponding to any bank is at an inactive level, indicating that an error uncorrectable by the on-die ECC occurs on the bank. Therefore, the row address selection circuit 2022 is enabled to choose to generate row address information corresponding to the bank, that is, the error row address information RA_UCE.

In some embodiments, with reference to FIG. 7 and FIG. 16, a specific process of step S222 includes the following step: A column address latch circuit 2031 outputs, in response to the read delay signal READ_DL, column address information CA corresponding to the read signal READ from the buffer as error column address information CA_UCE.

It should be noted that this embodiment may be implemented in cooperation with the memory provided in the foregoing embodiment. The related technical details described in the previous embodiment are still effective in this embodiment. To reduce repetition, the details are not described herein again.

An embodiment of the present disclosure further provides a storage device, including the memory provided in the foregoing embodiment and multiple ECC chips. Each of the ECC chips corrects, based on an address in a mode register in the memory, an error failing to meet a condition in the memory.

In an embodiment of the present disclosure, referring to FIG. 15, which is a schematic diagram of a compositional structure of a storage device 20 according to another embodiment of the present disclosure. As shown in FIG. 15, the storage device 20 includes multiple memories 10 provided based on the foregoing embodiments, and multiple ECC chips 30. Error row address information and error column address information in the memories 10 are configured to determine a data location at which an error failing to meet a condition occurs. Check data stored in the ECC chips 30 is configured to perform error checking and error correction on stored data and/or check data corresponding to the error row address information and the error column address information.

Specifically, the memory controller may read, from the storage device by employing a mode register read command (MRR or MRS), the error identification information UCE FLAG and the corresponding address information RA/CA that are stored in each memory chip, and determine whether the error identification information UCE FLAG in each memory marks that an error failing to meet a condition occurs on the corresponding memory chip. Specifically, when the error identification information UCE FLAG is at a first level, it indicates that an error failing to meet a condition occurs on the corresponding memory chip 10. The memory controller obtains the stored data of the corresponding address information and the check data in the ECC chip 30, and performs error checking/correction on the error failing to meet a condition in the memory chip 10. In this case, the check data in the ECC chip 30 is configured only to perform error checking and correction on the specified memory chip 10, without a need to perform error checking and correction on all the memory chips 10, thereby greatly improving error checking and correction capabilities. When the error identification information UCE FLAG is at a second level, no error failing to meet a condition occurs on the corresponding memory chip 10. The memory controller does not need to process the address information obtained from the corresponding memory 10, and does not need to perform error checking and correction processing on data of the address information.

The storage device 20 may be a dual inline memory module (Dual Inline Memory Modules, DIMM), including multiple memories 10 and multiple ECC chips 30. For example, as shown in FIG. 15, for the left and right sub-channels (sub-channel), two ECC chips and eight DRAM chips are included on each of the left and right sides. The ECC chip herein is a sideband ECC. For a sideband ECC that employs an RS encoding mode, in a case that an error location is not determined, an error correction capability of the RS algorithm is half of a check bit. Therefore, two ECC chips can correct a 2-bit error of one DRAM chip (one ECC chip is configured to determine a location, and one ECC chip is configured to correct an error). In a case that an error location is determined, an error correction capability of the RS algorithm is equal to a check bit. Therefore, two ECC chips can correct 2-bit errors of two DRAM chips. Herein, one sub-channel including two ECC chips is taken as an example. The memory 10 in the storage device 20 may pre-identify an error with two or more bits by employing the error checking circuit 100 and the error address generation circuit 200, and record a location corresponding to the error. The ECC chip 30 may directly correct the error. In this way, an error correction capability of a sideband ECC is doubled while keeping a structure of the storage device 20 unchanged, thereby improving accuracy of the storage device. A person of ordinary skill in the art may understand that multiple ECC chips may be disposed in one sub-channel to improve an error correction capability.

A person of ordinary skill in the art may understand that the foregoing implementations are specific embodiments for implementing this application. In actual application, various modifications may be made to the forms and details of the implementations without departing from the spirit and scope of this application. Any person skilled in the art may make changes and modifications without departing from the spirit and scope of this application. Therefore, the protection scope of this application shall be subject to the scope defined by the claims.

## Claims

1. A memory (10), comprising:
a plurality of banks, each of the banks comprising a plurality of data memory array tiles and an ECC memory array tile;
a plurality of error checking circuits (100) having a one-to-one correspondence with the plurality of banks;
each of the error checking circuits (100) being configured to respectively read stored data and check data from the plurality of data memory array tiles and the ECC memory array tile of the corresponding bank, and generate a corresponding error checking signal (UCE_flag) based on the stored data and the check data, the error checking signal (UCE_flag) being configured to indicate whether an error meeting a condition occurs on the stored data and/or the check data of the corresponding bank; and
an error address generation circuit (200), configured to receive the plurality of error checking signals (UCE_flag) from the plurality of error checking circuits (100), and store address information corresponding to an error failing to meet a condition when any one of the error checking signals (UCE_flag) is at an inactive level; the address information comprising error row address information (RA_UCE) and error column address information (CA_UCE).

2. The memory (10) according to claim 1, wherein
the error address generation circuit (200) is further configured to generate and store error identification information (UCE FLAG) when any one of the error checking signals (UCE_flag) is at an inactive level; the error identification information (UCE FLAG) being configured to indicate whether an error failing to meet a condition occurs on stored data and/or check data corresponding to the stored address information.

3. The memory (10) according to any one of claims 1 and 2, wherein the error checking circuit (100) comprises:
a first checking circuit (101), configured to receive the stored data and the check data, and compare a check code generated based on the stored data with the check data to generate a comparison result; and
a first determining circuit (102), configured to receive the comparison result and determine whether the comparison result meets a condition, and generate the error checking signal (UCE_flag) at an active level when the comparison result meets the condition, or generate the error checking signal (UCE_flag) at an inactive level when the comparison result does not meet the condition.

4. The memory (10) according to any one of claims 1 to 3, wherein the error address generation circuit (200) comprises:
a combining circuit (201), configured to receive the plurality of error checking signals (UCE_flag) corresponding to the plurality of banks, and combine the plurality of error checking signals to generate an error checking total signal (UCE_flag_all), wherein when any one of the error checking signals (UCE_flag) is at an inactive level, the generated error checking total signal (UCE_flag_all) is at an inactive level;
a row address generation circuit (202), configured to receive the plurality of error checking signals (UCE_flag) and the error checking total signal (UCE_flag_all), and when any one of the error checking signals (UCE_flag) is at an inactive level, output row address information of the corresponding bank as error row address information (RA_UCE), and store the error row address information (RA_UCE) in response to the error checking total signal (UCE_flag_all) at an inactive level; and
a column address generation circuit (203), configured to store error column address information (CA_UCE) corresponding to an error failing to meet a condition in response to the error checking total signal (UCE_flag_all) at an inactive level.

5. The memory (10) according to claim 4, wherein the row address generation circuit (202) comprises:
a plurality of row address latch circuits (2021) having a one-to-one correspondence with the plurality of banks, each of the row address latch circuits (2021) being configured to latch, in response to an activation signal of the corresponding bank, row address information corresponding to the activation signal;
a row address selection circuit (2022), configured to receive the plurality of error checking signals (UCE_flag) and a plurality of pieces of row address information latched by the plurality of row address latch circuits (2021), and when any one of the error checking signals (UCE_flag) is at an inactive level, output corresponding row address information as error row address information (RA_UCE); and
a row address storage circuit (2023), configured to store the error row address information (RA_UCE) in response to the error checking total signal (UCE_flag_all) at an inactive level.

6. The memory (10) according to claim 5, wherein the column address generation circuit (203) comprises:
a column address latch circuit (2031), configured to input, in response to a read signal, column address information corresponding to the read signal into a buffer, and output, in response to a read delay signal, the column address information corresponding to the read signal from the buffer as error column address information (CA_UCE); the read delay signal being a delay signal of the read signal; and
a column address storage circuit (2032), configured to store the error column address information (CA_UCE) into a corresponding mode register in response to the error checking total signal (UCE_flag_all) at an inactive level.

7. The memory (10) according to claim 6, wherein the row address storage circuit (2023) comprises N serially connected row address storage subcircuits;
a 1st row address storage subcircuit (2023_1) being configured to store received error row address information (RA_UCE) when an error checking total signal (UCE_flag_all) on which a first delay is performed for N-1 times is at an inactive level; an ith row address storage subcircuit (2023_i) being configured to receive and store error row address information (RA_UCE) stored in an (i-1)th row address storage subcircuit, when an error checking total signal (UCE_flag_all) on which a first delay is performed for N-i times is at an inactive level; and an Nth row address storage subcircuit (2023_N) being configured to receive and store error row address information (RA_UCE) stored in an (N-1)th row address storage subcircuit, when the error checking total signal (UCE_flag_all) is at an inactive level; the first delay being several clock cycles, N being greater than or equal to 2, and i being a positive integer greater than 1 and less than N; and
the column address storage circuit (2032) comprises N serially connected column address storage subcircuits;
a 1st column address storage subcircuit (2032_1) being configured to store received error column address information when an error checking total signal (UCE_flag_all) on which a second delay is performed for N-1 times is at an inactive level; a jth column address storage subcircuit (2032_j) being configured to receive and store error column address information (CA_UCE) stored in a (j-1)th column address storage subcircuit, when an error checking total signal (UCE_flag_all) on which a second delay is performed for N-j times is at an inactive level; and an Nth column address storage subcircuit (2032_N) being configured to receive and store error column address information (CA_UCE) stored in an (N-1)th column address storage subcircuit, when the error checking total signal (UCE_flag_all) is at an inactive level; the second delay being several clock cycles, and j being a positive integer greater than 1 and less than N.

8. A memory operation method, a memory comprising a plurality of banks, each of the banks comprising a plurality of data memory array tiles and an ECC memory array tile, and the operation method comprising:
receiving stored data and check data that are respectively read from the plurality of data memory array tiles and the ECC memory array tile of any one of the banks, and generating a corresponding error checking signal based on the stored data and the check data (S1); the error checking signal being configured to indicate whether an error meeting a condition occurs on the stored data and/or the check data of the corresponding bank; and
receiving the error checking signal, and storing address information corresponding to an error failing to meet a condition when the error checking signal is at an inactive level (S2); the address information comprising error row address information and error column address information.

9. The operation method according to claim 8, wherein
error identification information is generated and stored when the error checking signal is at an inactive level (S3); the error identification information being configured to indicate whether an error failing to meet a condition occurs on stored data and/or check data corresponding to the stored address information.

10. The operation method according to any one of claims 8 and 9, before the receiving stored data and check data that are respectively read from the plurality of data memory array tiles and the ECC memory array tile of the corresponding bank, further comprising:
receiving, in response to an activation signal, row address information of a bank corresponding to the activation signal, and latching the row address information (S00); and
receiving, in response to a read signal, column address information corresponding to the read signal, and inputting the column address information into a buffer (S01).

11. The operation method according to any one of claims 8 to 10, wherein the generating a corresponding error checking signal based on the stored data and the check data comprises:
generating a check code based on the stored data, and comparing the check code with the check data to generate a comparison result (S11); and
receiving the comparison result and determining whether the comparison result meets a condition, and generating the error checking signal at an active level when the comparison result meets the condition, or generating the error checking signal at an inactive level when the comparison result does not meet the condition (S12).

12. The operation method according to claim 10, wherein the receiving the error checking signal, and storing address information corresponding to an error failing to meet a condition when the error checking signal is at an inactive level comprises:
receiving a plurality of error checking signals corresponding to a plurality of banks, and combining the plurality of error checking signals to generate an error checking total signal, wherein when any one of the error checking signals is at an inactive level, an error checking total signal at an inactive level is generated (S21);
selecting the received address information in response to the plurality of error checking signals to generate error row address information and error column address information (S22); and
storing the error row address information and the error column address information in response to the error checking total signal (S23).

13. The operation method according to claim 12, wherein the selecting the received address information in response to the plurality of error checking signals to generate error row address information and error column address information comprises:
receiving the plurality of error checking signals and a plurality of pieces of row address information corresponding to the plurality of banks, and when any one of the error checking signals is at an inactive level, outputting row address information of the corresponding bank as error row address information (S221); and
outputting, in response to a read delay signal, the column address information corresponding to the read signal from the buffer as error column address information (S222); the read delay signal being a delay signal of the read signal.

14. A storage device (20), comprising a plurality of memories (10) according to any one of claims 1 to 7 and a plurality of ECC chips (30);
the error row address information and the error column address information in the memories (10) being configured to determine a data location at which an error failing to meet a condition occurs, and check data stored in the ECC chips (30) being configured to perform error checking and error correction on stored data and/or check data corresponding to the error row address information and the error column address information.
